# EUROPEAN PATENT APPLICATION

(11) **EP 4 845 027 A1**
(43) Date of publication of application: **25.11.2026**
(21) Application number: 26173763.9
(22) Date of filing: 21.04.2026
(51) Int. Cl.: H03F 3/45, H03F 3/193, H03F 3/195

(54) **TRANSIMPEDANCE AMPLIFIER WITH DIGITALLY STABILIZED BIASING CIRCUIT**

(30) Priority: 20.05.2025 US 202519213048
(71) Applicant: STMicroelectronics International N.V., 1228 Plan-les-Ouates, Geneva (CH)
(72) Inventor: DEBNATH, Chandrajit, 560103 Bengaluru (IN); PAUL, Rik, 700002 Kolkata, West Bengal (IN)
(74) Representative: Buzzi, Notaro & Antonielli d'Oulx S.p.A.

(57) **Abstract**

According to an embodiment, a transimpedance amplifier, TIA circuitincludes a core amplifier section with an internal common mode node and digitally trimmable bias current sources. A controller performs a calibration procedure by measuring the internal common mode node voltage, measuring a reference common mode voltage, and setting the digitally trimmable bias current sources to equalize the internal common mode node voltage with the reference common mode voltage.

## Description

### TECHNICAL FIELD

The present disclosure relates to electronic systems and, in particular embodiments, to a transimpedance amplifier with a digitally stabilized biasing circuit.

### BACKGROUND

Transimpedance amplifiers (TIAs) play an important role in many signalprocessing systems, particularly radar applications. These amplifiers convert current signals into voltage signals, often serving as one of the first-stages in receiver chains. In automotive applications, radar systems operating at millimeter-wave frequencies, such as 77 GHz, may utilize TIAs as part of their receiver analog front-end architecture.

The automotive radar market continues to grow as advanced driver assistance systems (ADAS) and autonomous driving capabilities expand across vehicle platforms. Various manufacturers develop radar systems that can detect objects at various distances, determine relative speeds, and assist with functions ranging from adaptive cruise control to emergency braking. These systems may operate in different frequency bands, with 77 GHz becoming increasingly common for medium and long-range applications.

In radar receiver chains, the incoming radio frequency (RF) signal typically passes through a low-noise amplifier before reaching a mixer that down-converts the signal to a lower frequency. The mixer output can be a current that requires conversion to a voltage for subsequent processing stages. TIAs may perform this current-to-voltage conversion while adding gain to the signal path.

Radar systems can benefit from high-pass and low-pass signal paths in their processing chain. The blocker signals (usually low-frequency signals with high power coming off by reflecting from stationary objects like car bumpers, etc.) are important to be filtered so that it doesn't create a false target for the system.

Noise performance represents an important parameter for radar receiver chains. The noise figure, expressed in decibels (dB), characterizes how much the signal-to-noise ratio degrades as signals pass through components like TIAs. Lower noise figures correspond to better sensitivity and potentially longer detection ranges for radar systems.

### SUMMARY

Technical advantages are generally achieved by embodiments of this disclosure, which describe a transimpedance amplifier with a digitally stabilized biasing circuit. A first aspect relates to a system, comprising a transimpedance amplifier (TIA) circuit including a core amplifier section having an internal common mode node, a first-stage common mode feedback circuit coupled to the core amplifier section, and a plurality of digitally trimmable bias current sources coupled to the core amplifier section; a sense analog-to-digital converter (ADC) coupled to the TIA circuit and configured to compare a first voltage measured at the internal common mode node with a second voltage measured at a reference common mode voltage; and a controller coupled to the sense ADC and the TIA circuit, the controller configured to: generate digital trim signals based on the comparison between the first voltage and the second voltage, and provide the digital trim signals to the digitally trimmable bias current sources to adjust a bias current such that the voltage at the internal common mode node equals the reference common mode voltage.

A second aspect relates to a system, comprising a circuit including: a transimpedance amplifier (TIA) having an internal common mode node, a first-stage common mode feedback circuit coupled to the TIA, and a plurality of digitally trimmable bias current sources coupled to the TIA; a test multiplexer coupled to the circuit and configured to selectively route the internal common mode node and a reference common mode voltage to external pins; automated test equipment (ATE) couplable to the external pins and configured to compare a first voltage measured at the internal common mode node with a second voltage measured at the reference common mode voltage; and a controller couplable to the ATE and the circuit, the controller configured to: receive comparison results from the ATE, generate digital trim signals based on the comparison results, and provide the digital trim signals to the digitally trimmable bias current sources to adjust bias currents such that the first voltage equals the second voltage.

A third aspect relates to a system, comprising a circuit including: a transimpedance amplifier (TIA) having an internal common mode node, a first-stage common mode feedback circuit coupled to the TIA, and a plurality of digitally trimmable bias current sources coupled to the TIA; a first comparator having a first input coupled to the internal common mode node, a second input coupled to a first threshold voltage equal to a reference common mode voltage plus a voltage margin, and an output providing a first comparator signal; a second comparator having a first input coupled to the internal common mode node, a second input coupled to a second threshold voltage equal to the reference common mode voltage minus the voltage margin, and an output providing a second comparator signal; and a controller coupled to the first and second comparators and the circuit, the controller configured to: monitor the first comparator signal and the second comparator signal, detect temperature-induced drift when either of the first comparator and the second comparator signals changes state, and adjust the digitally trimmable bias current sources to restore a voltage at the internal common mode node to a value between the first and second threshold voltages.

Embodiments can be implemented in hardware, software, or any combination thereof.

### BRIEF DESCRIPTION OF THE DRAWINGS

For a more complete understanding of the present disclosure and the advantages thereof, reference is now made to the following descriptions taken in conjunction with the accompanying drawings, in which:
Figure 1 is a diagram of an exemplary transimpedance amplifier (TIA) circuit with an integrated first-order high-pass filter;
Figure 2A is a diagram of a digitally stabilized transimpedance amplifier (TIA) circuit;
Figure 2B is a diagram of a first-stage common mode feedback (CMFB) circuit that works with the second-stage CMFB circuits shown in Figure 2A;
Figure 3A is a diagram of a digitally trimmable P-type bias current source;
Figure 3B is a diagram of a digitally trimmable N-type bias current source;
Figure 3C is a diagram of a digitally trimmable P-type bias current source;
Figure 3D is a diagram of a digitally trimmable N-type bias current source;
Figure 4A is a diagram of a digitally trimmable P-type bias current source;
Figure 4B is a diagram of a digitally trimmable N-type bias current source;
Figure 5 is a flowchart diagram of a calibration method for calibrating a digitally stabilized transimpedance amplifier;
Figure 6 is a diagram exemplary of a controller;
Figure 7 is a diagram exemplary of a digital trimming and calibration system;
Figure 8 is a diagram exemplary of a test and calibration system; and
Figure 9 is a diagram exemplary of a temperature drift management and calibration system.

### DETAILED DESCRIPTION OF ILLUSTRATIVE EMBODIMENTS

This disclosure provides many applicable inventive concepts that can be embodied in a wide variety of specific contexts. The particular embodiments are merely illustrative of specific configurations and do not limit the scope of the claimed embodiments. Features from different embodiments may be combined to form further embodiments unless noted otherwise. Various embodiments are illustrated in the accompanying drawing figures, where identical components and elements are identified by the same reference number, and repetitive descriptions are omitted for brevity.

Variations or modifications described in one of the embodiments may also apply to others. Further, various changes, substitutions, and alterations can be made herein without departing from the spirit and scope of this disclosure as defined by the appended claims.

While the aspects are described primarily in the context of automotive radar receiver front-end circuits operating at high frequencies, these aspects may also apply to other communication and sensing systems that utilize transimpedance amplifiers. In particular, aspects of this disclosure may similarly apply to optical communication receivers, LiDAR systems, medical imaging equipment, wireless communication infrastructure, industrial sensors, and consumer electronics. Startup techniques and low-noise design approaches can benefit applications where high sensitivity and reliable operation are desirable characteristics.

Embodiments of the disclosure provide a transimpedance amplifier with a digitally stabilized biasing circuit that addresses stability challenges in conventional designs. The transimpedance amplifier includes a core amplifier section with an internal common mode node and digitally trimmable bias current sources that establish operating points without relying on conventional analog feedback loops. In embodiments, a controller calibrates the internal common mode node voltage, compares it to a reference common mode voltage, and adjusts the bias currents to equalize these voltages.

The digitally stabilized approach replaces problematic inner common-mode feedback loops with digital calibration, eliminating oscillation risks. The ultra-low noise requirement of the TIA requires the use of a complementary input stage as a mandate, since noise performance can't be achieved in the conventional op-amp structures. In this way, input stage bias current is made very high with respect to the load stage bias current, achieving the ultra-low noise criteria. This type of complementary input stage conventional architecture now will require typically 4-stage common mode feedback loop for DC biasing, which are typically very complex for implementation and have inherent stability concerns, particularly across process, voltage, and temperature variations. Moreover, dual interacting common mode loops as a solution aren't preferred since they can limit the noise performance due to limitations on the capacitance at bias and input pair stages. Further, dual interacting common mode loops have inherent stability problems and oscillations & hence can cause functional failures. Thus, for ultra-low noise high-performance TIA, these are not preferred. By separating common-mode control through digital calibration of bias currents, the disclosed architecture improves stability while preserving noise performance characteristics.

Digital calibration can be implemented through various configurations of biased current sources, including parallel arrangements of transistors with switches for binary-weighted current adjustment or cascode arrangements with operational amplifier feedback. These implementations provide control over bias conditions while offering advantages in boosting output impedance, Process-Voltage-Temperature (PVT) drift immunity, and Common Mode Rejection Ratio (CMRR) and PSRR.

Temperature drift management capabilities further enhance the robustness of the digitally stabilized transimpedance amplifier. Comparator-based monitoring can detect when the internal common mode voltage drifts outside an acceptable window due to temperature changes, triggering recalibration during idle periods to maintain optimal performance across varying thermal conditions.

The disclosed architecture can achieve exceptional performance metrics for demanding applications such as automotive radar systems. While beneficial for automotive radar receiver front-end circuits operating at millimeter-wave frequencies, the approach may also apply to other communication and sensing systems that utilize transimpedance amplifiers, including optical communication receivers, Light Detection and Ranging (LiDAR) systems, and wireless communication infrastructure. These and additional details are further discussed below.

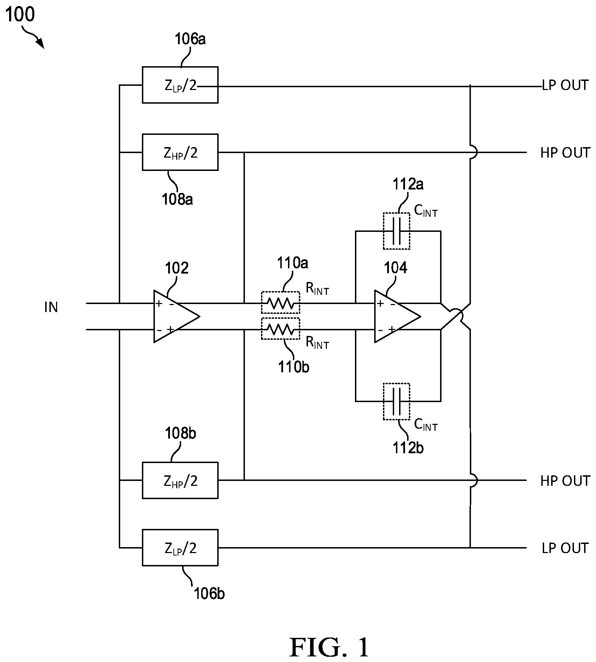

Figure 1 illustrates a schematic diagram of a transimpedance amplifier (TIA) circuit 100 with an integrated first-order high-pass filter, as an example. In embodiments, the TIA circuit 100 can be implemented as part of the baseband signal processing chain in the receive path of an RF signal processing chain. TIA circuit 100 can be employed in various applications, such as automotive radar systems, fifth-generation (5G) base stations, satellite radio systems, and the like.

TIA circuit 100 includes a high-pass filter (HPF) operational amplifier (OPAMP) 102 and a low-pass filter (LPF) OPAMP 104, where the LPF OPAMP 104 is in the feedback path of the HPF OPAMP 102. The output of the HPF OPAMP 102 is the final output of the TIA circuit 100. The HPF OPAMP 102 receives input current IN at its differential inputs and provides a gain equivalent to the resistance in its feedback, given by impedance element 108a-108b (e.g., equal to Z_{HP}/2). The TIA circuit 100 includes feedback from LPF OPAMP 104 by impedance elements 106a-106b, which establishes the circuit's filtering characteristics (e.g., equal to Z_{LP}/2). The output of HPF OPAMP 102 is fed to LPF OPAMP 104, which forms an integrator by using the integrating resistors (R_{INT}) 110a-110b and integrating capacitors (C_{INT}) 112a-112b. The integrating resistors (R_{INT}) 110a-110b are coupled from the differential outputs of HPF OPAMP 102 to the inputs of LPF OPAMP 104. Additionally, integrating capacitors 112a-112b are coupled across the LPF OPAMP 104, forming the integrating elements of the low-pass filter structure. The LPF OPAMP 104 present in the feedback of HPF OPAMP 102 allows the generation of the high-pass response, filters the low-frequency signal, and allows the high-frequency main signals to pass with high gain.

As illustrated, TIA circuit 100 employs a bi-quad filter architecture, characterized by its two operational amplifiers interconnected with feedback elements. This configuration enables the filtering of blocker or the low-frequency signal, but also allows passing of the high-frequency signal, which is of main interest. While the embodiments described throughout this disclosure reference this particular bi-quad filter implementation, the principles and techniques presented may be advantageous to other transimpedance amplifier topologies beyond the specific structure shown in Figure 1. Accordingly, the disclosed concepts remain applicable across different TIA circuit configurations that may benefit from similar performance enhancements.

For example, the TIA circuit 100 can maintain approximately a 12dB ratio across the frequency spectrum between the high-pass HP OUT and low-pass LP OUT outputs. At lower frequencies (between 1 and 100 kHz), the low-pass output LP OUT provides a relatively flat response, while the high-pass output HP OUT exhibits strong attenuation. As frequency increases, the high-pass output HP OUT rises with a positive slope while the low-pass output LP OUT eventually begins to roll off with a negative slope above approximately 100 kHz. The crossover point occurs around 100 kHz, when both outputs have similar gains.

This frequency response characteristic helps increase the circuit's overall gain while reducing the front end's noise figure (NF). The low-pass output path processes low-frequency signals primarily from bumper or nearby targets in radar applications, while the high-pass path handles higher-frequency components. The circuit design enables achieving a low noise figure, superior blocker power tolerance, and improved intermodulation distortion performance.

Conventionally, the HPF OPAMP 102 may be implemented using telescopic cascode or folded cascode architectures, each presenting distinct challenges for achieving ultra-low noise performance while maintaining stability. The telescopic cascode approach offers simplicity and potential for high gain, but typically distributes bias currents uniformly through input and load devices. This equal current distribution creates comparable transconductance values between input and load transistors, resulting in substantial noise contribution from the load devices. For optimal noise performance, input transconductance should significantly exceed load transconductance, which standard telescopic implementations struggle to achieve naturally.

The folded cascode architecture addresses limitations by enabling unequal current distribution between input and load devices. This configuration requires higher current in bias branches than the input branches to support the folding branch current, potentially degrading the noise numbers. Further, both architectures face challenges when implemented with the common-mode feedback required for stable operation.

Conventional biasing and common-mode control approaches necessitate complex feedback loops that create inherent stability concerns. The compensation techniques for stabilizing such feedback structures, particularly Nested Miller compensation, are susceptible to oscillation and require high-value capacitors that increase circuit area.

Additionally, the common mode bandwidth in these implementations tends to be low, resulting in reduced Common Mode Rejection Ratio (CMRR) and degraded intermodulation distortion performance. These limitations make conventional approaches inadequate for applications requiring exceptional performance metrics, such as automotive radar systems.

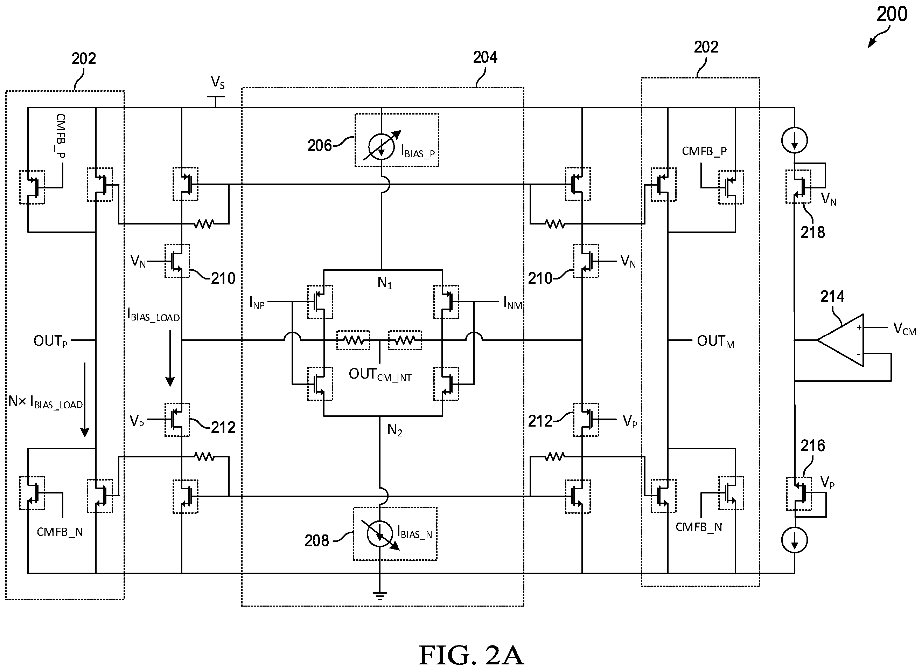

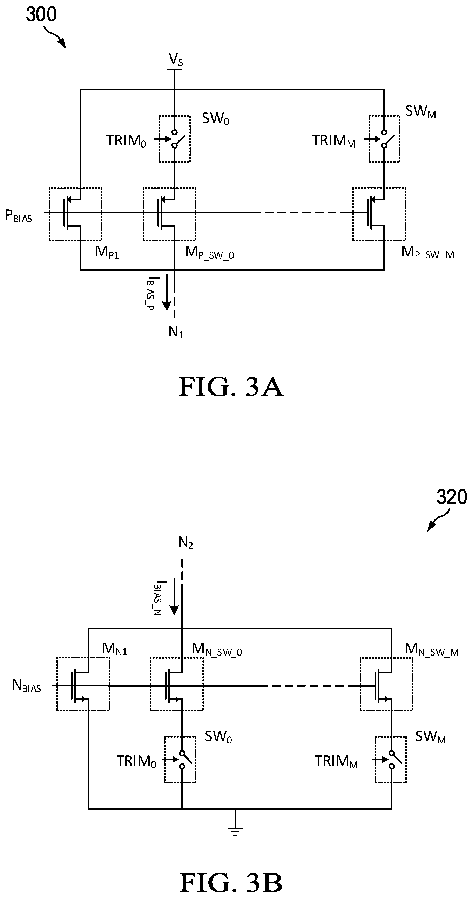

Figures 2A-B and 3A-B illustrate schematic diagrams of a digitally stabilized transimpedance amplifier architecture that eliminates the conventional design's problematic inner common-mode feedback loop. By replacing analog feedback with digital calibration of bias currents, the circuits achieve stable operation without oscillation risks while maintaining the ultra-low noise performance for high-performance radar receiver applications.

Figure 2A illustrates a schematic diagram of a digitally stabilized transimpedance amplifier (TIA) circuit 200, according to an embodiment of the disclosure. The TIA circuit 200 addresses the limitations of conventional designs through a double common-mode loop approach with digital calibration. TIA circuit 200 may include additional components (not visible for the sake of simplicity).

TIA circuit 200 includes a core amplifier section 204 (which has a digital CMFB loop) flanked by second-stage CMFB circuits 202 (analog in nature). The core amplifier section 204 receives differential input current signals (I_{NP} and I_{NM}) and processes them to generate differential output signals (OUT_{P} and OUT_{M}). The internal common mode node (OUT_{CM_INT}) at the core amplifier section 204 serves as the monitoring point for digital calibration, replacing what would conventionally be an analog feedback loop.

In embodiments, the core amplifier section 204 includes digitally trimmable bias current sources: a P-type bias current source (I_{BIAS_P}) 206 and an N-type bias current source (I_{BIAS_N}) 208. These digitally trimmable bias current sources establish the operating points for the transistors in the signal path and digitize what was conventionally performed by an analog common-mode feedback loop.

In conventional designs, a separate circuit continuously monitors the internal common mode node (OUT_{CM_INT}), compares its value to the reference common mode voltage (V_{CM}), and adjusts transistor gate voltages based on the error calculated by an error amplifier. In the present disclosure, the approach above has been replaced by the digitally trimmable current sources 206 and 208, which are calibrated during a foreground calibration process.

By making the internal common mode node OUT_{CM_INT} equal to the reference common mode voltage V_{CM}, the source terminals of the N-channel transistors 210 and P-channel transistors 212 are forced to the reference common mode voltage V_{CM}, resulting in the second stage biasing V_{P} and V_{N} being accurate and stable. This approach ensures proper operation of the entire signal chain without relying on multiple interacting feedback loops that could lead to instability.

The internal common mode node OUT_{CM_INT} is measured and compared against the reference common mode voltage V_{CM} during foreground calibration. Based on the comparison, a controller (not visible for the sake of simplicity) coupled to the P-type bias current source (I_{BIAS_P}) 206 and the N-type bias current source (I_{BIAS_N}) 208 adjusts the bias currents so that the internal common-mode node (OUT_{CM_INT}) equals the reference common-mode voltage (V_{CM}).

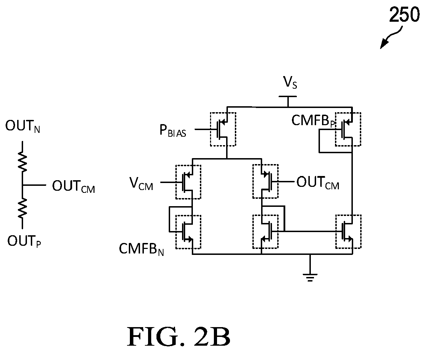

The VCM buffer 214 generates two bias voltages V_{P} and V_{N}. V_{P} being equal to the reference common-mode voltage (V_{CM}) minus the threshold voltage (V_{TP}) of the P-channel transistor 216. V_{N} equals the reference common-mode voltage (V_{CM}) minus the threshold voltage (V_{TN}) of the N-channel transistor 218. V_{P} and V_{N} bias the cascode P-channel transistors 212 and the N-channel transistors 210, respectively. Figure 2B illustrates a schematic diagram of a first-stage common mode feedback (CMFB) circuit 250 that works with the second-stage CMFB circuits 202 shown in Figure 2A. These circuits form the complete CMFB outer loop that maintains proper output common mode voltage levels. The first-stage CMFB circuit 250 processes the differential outputs (OLT_{P} and OUT_{M}) through resistive dividers to generate a common mode signal (OUT_{CM}).

The extracted common mode signal (OUT_{CM}) is compared with the reference common mode voltage (V_{CM}) through a differential amplifier structure. Based on this comparison, the circuit generates a first control signal (CMFB_{P}) and a second control signal (CMFB_{N}), which are applied to the gate terminals of the transistors in the second-stage CMFB circuits 202.

The circuit includes P-type and N-type feedback paths that provide these control signals to adjust the bias conditions of the second stage based on the detected common mode voltage deviation from the reference.

The overall architecture employs a double common-mode loop approach, where the CMFB outer loop (comprising the first-stage CMFB circuit 250 and second-stage CMFB circuits 202) handles output common-mode control. At the same time, the core amplifier section 204 implements a digital foreground common-mode loop through the trimmable current sources. Unlike conventional designs with multiple interacting analog feedback loops, separating common-mode control fundamentally improves stability while maintaining ultra-low noise performance. While the CMFB outer loop maintains the output common mode voltage at the desired level through continuous analog feedback, the inner loop's digital calibration ensures that internal nodes are properly biased without introducing the stability problems associated with conventional multi-loop analog feedback approaches.

Figure 3A illustrates a schematic diagram of a digitally trimmable P-type bias current source 300, according to an embodiment of the disclosure. In an embodiment, the digitally trimmable P-type bias current source 300 implements the P-type bias current source (I_{BMS_P}) 206 shown in Figure 2A, replacing what would conventionally be controlled by an analog feedback loop.

The digitally trimmable P-type bias current source 300 includes multiple P-channel transistors (M_{P1} and M_{P_SW_o} through M_{P_SW_M}) arranged in parallel. In embodiments, one or more of the P-channel transistors are controllable by a switch (SWₒ through SW_{M}) coupled to the source terminals of the transistors, where M is an integer greater than one. All P-channel transistors share a common bias voltage (P_{BIAS}) at their gate terminals, while their contributions to the output current are controlled digitally.

By turning ON one or more switchable transistors (by coupling the source terminals to the supply voltage V_{S}) in the P-type bias current source 300, the total current (I_{BIAS_P}) is increased, resulting in additional current being pumped into TIA circuit 200 at node N₁. In contrast, by turning OFF one or more switchable transistors (by decoupling the source terminals of the switchable transistors from the supply voltage V_{S}) in the P-type bias current source 300, the total current (I_{BIAS_P}) is decreased, resulting in less current being pumped into TIA circuit 200 at node N₁.

Accordingly, the switches allow individual switchable transistors to be enabled or disabled, creating a binary-weighted current adjustment capability. The total current (I_{BIAS_P}) can be discretely adjusted during calibration by controlling the switch settings through digital trim bits (e.g., TRIM₀). This digital approach replaces the conventional analog method, where a continuous error signal from a feedback amplifier would adjust transistor gate voltages. During calibration, these switches are controlled based on comparing the internal common mode node (OUT_{CM_INT}) at the core amplifier section 204 and the reference common mode voltage (V_{CM}) to achieve the desired operating point.

It should be appreciated that the digitally trimmable P-type bias current source 300 may include additional components not shown. The number of transistors and switches of the digitally trimmable P-type bias current source 300 is non-limiting, and fewer or greater numbers are contemplated in embodiments.

Figure 3B illustrates a schematic diagram of a digitally trimmable N-type bias current source 320, according to an embodiment of the disclosure. In an embodiment, the digitally trimmable N-type bias current source 320 implements the N-type bias current source (I_{BIAS_N}) 208 shown in Figure 2A, providing complementary current control to the P-type source.

The digitally trimmable N-type bias current source 320 includes multiple N-channel transistors (M_{N1} and M_{N_SW_o} through M_{N_SW_M}) arranged in parallel, with one or more transistors controlled by a switch (SWₒ through SW_{M}) coupled to the source terminals of the transistors, where M is an integer greater than one. All N-channel transistors share a common bias voltage (N_{BIAS}) at their gates, while their contribution to the sink current is digitally controlled.

By turning ON one or more switchable transistors (by coupling the source terminals to ground) in the N-type bias current source 320, the total current (I_{BIAS_N}) is increased, resulting in additional current being pulled in TIA circuit 200 at node N₂. In contrast, by turning OFF one or more switchable transistors (by decoupling the source terminals from ground) in the N-type bias current source 320, the total current (I_{BIAS_N}) is decreased, resulting in less current being pulled in TIA circuit 200 at node N₂.

In embodiments, the same digital trim bit (e.g., TRIM₀, TRIM₁, etc.) can be used for the P-type bias current source 300 and the N-type bias current source 320 but with complimentary control (e.g., If trim<N> increases/decreases the P-side current, then trim_b<N> simulatenously decreases/increases the N-side current), allowing for a single trim-bit change to modify both current sources simultaneously and extending the range for a single trim code.

It should be appreciated that the digitally trimmable N-type bias current source 320 may include additional components not shown. The number of transistors and switches of the digitally trimmable N-type bias current source 320 is non-limiting, and fewer or greater numbers are contemplated in embodiments.

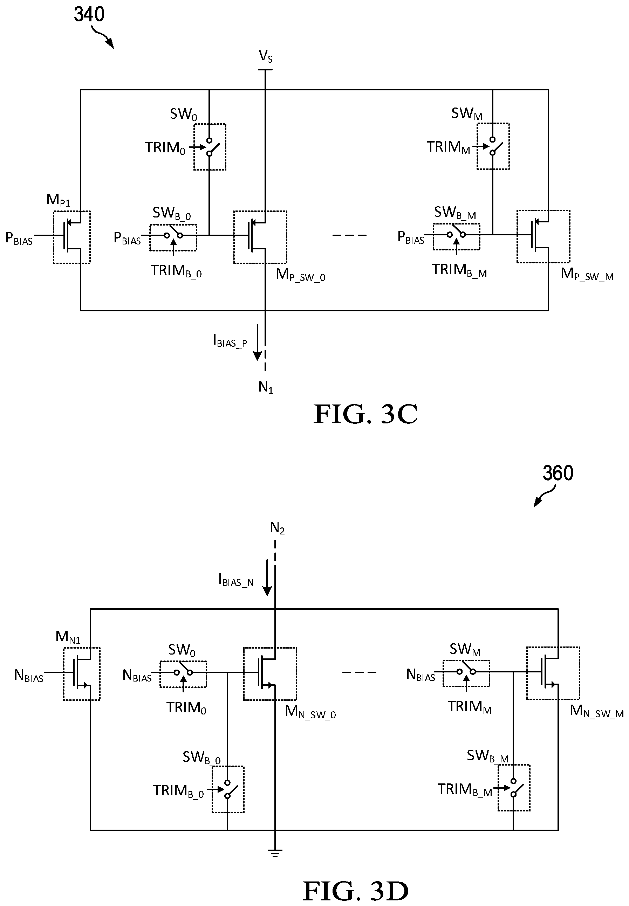

Figure 3C illustrates a schematic diagram of a digitally trimmable P-type bias current source 340, according to an embodiment of the disclosure. In an embodiment, the digitally trimmable P-type bias current source 300 implements the P-type bias current source (I_{BIAS_P}) 206 shown in Figure 2A, replacing what would conventionally be controlled by an analog feedback loop.

The digitally trimmable P-type bias current source 340 includes multiple P-channel transistors (M_{P1} and M_{P_SW_o} through M_{P_SW_M}) arranged in parallel. In embodiments, the switchable P-channel transistors (M_{P_SW_o} through M_{P_SW_M}) are controllable by a first set of switches (SW_{B_o} through SW_{B_M}) and a second set of switches (SWₒ through SW_{M}) coupled to their gate terminals, where M is an integer greater than one.

The P-channel transistor (M_{P1}) is shown to have a fixed always-on configuration due to the fact that there are no switches at its gate terminal. Hence, the P-channel transistor (M_{P1}) current source is always on with a fixed current value.

The first set of switches (SW_{B_o} through SW_{B_M}) and the second set of switches (SWₒ through SW_{M}) operate in a complementarity manner, such that when switches in the first set are closed, corresponding switches in the second set will be open, or vice versa. For example, to turn on the first switchable transistor (M_{P_SW_o}), the first trim code (TRIMₒ) is set such that the first switch (SWₒ) of the second set of switches is open and the complementary first trim code (TRIM_{B_o}) to causes the first switch (SW_{B_o}) of the first set of switches to be in a closed position. By turning ON one or more switchable transistors (by coupling the gate terminals to the common bias voltage P_{BIAS}) in the P-type bias current source 340, the total current (I_{BIAS_P}) is increased, resulting in additional current being pumped into TIA circuit 200 at node N₁. In contrast, by turning OFF one or more switchable transistors (by pulling up the gate of the switchable transistors to the supply voltage V_{S}) in the P-type bias current source 340, the total current (I_{BIAS_P}) is decreased, resulting in less current being pumped into TIA circuit 200 at node N₁. Accordingly, the various switches allow individual switchable transistors to be enabled or disabled, creating a binary-weighted current adjustment capability. The total current (I_{BIAS_P}) can be discretely adjusted during calibration by controlling the switch settings through digital trim bits (e.g., TRIMₒ). This digital approach replaces the conventional analog method, where a continuous error signal from a feedback amplifier would adjust transistor gate voltages. During calibration, these switches are controlled based on comparing the internal common mode node (OUT_{CM_INT}) at the core amplifier section 204 and the reference common mode voltage (V_{CM}) to achieve the desired operating point.

The placement of the switches at the gate terminals of the transistors in Figure 3C, in contrast to the placement of the switches at the source terminals of the transistors in Figure 3A prevents a voltage drop on the switches due to high current. In addition, the arrangement shown in Figure 3C improves current matching and device matching.

It should be appreciated that in some embodiments, switches may be placed at the gate terminals and the source terminals of the transistors (not shown) in a digitally trimmable P-type bias current source (i.e., a combination of the arrangement shown in Figures 3A and 3C). Further, the digitally trimmable P-type bias current source 300 may include additional components not visible for the sake of simplicity. The number of transistors and switches of the digitally trimmable P-type bias current source 300 is non-limiting, and fewer or greater numbers are contemplated in embodiments.

Figure 3D illustrates a schematic diagram of a digitally trimmable N-type bias current source 360, according to an embodiment of the disclosure. In an embodiment, the digitally trimmable N-type bias current source 360 implements the N-type bias current source (I_{BIAS_N}) 208 shown in Figure 2A, providing complementary current control to the P-type source.

The digitally trimmable N-type bias current source 360 includes multiple N-channel transistors (M_{N1} and M_{N_SW_o} through M_{N_SW_M}) arranged in parallel. In embodiments, the switchable N-channel transistors (M_{N_SW_o} through M_{N_SW_M}) are controllable by a first set of switches (SW_{B_o} through SW_{B_M}) and a second set of switches (SWₒ through SW_{M}) coupled to their gate terminals, where M is an integer greater than one.

The N-channel transistor (M_{N1}) is shown having an always-on configuration due to no switches at its gate terminal. Hence, the N-channel transistor (MN1) current source is always on with a fixed current value. We need to ensure the N-channel transistor (M_{N1}) current source value is same with the P-channel transistor (M_{P1}) current source of Figure 3A for reliable design.

For instance, the first set of switches (SW_{B_o} through SW_{B_M}) and the second set of switches (SWₒ through SW_{M}) operate in a complementarity manner, such that when switches in the first set are closed, corresponding switches in the second set are open, or vice versa. For example, to turn on the first switchable transistor (M_{N_SW_o}), the first trim code (TRIMₒ) is set such that the first switch (SWₒ) of the second set of switches is closed and the complementary first trim code (TRIM_{B_o}) causes the first switch (SW_{B_o}) of the first set of switches to be in an open position. By turning ON one or more switchable transistors (by coupling the gate terminals to the common bias voltage (N_{BIAS})) in the N-type bias current source 360, the total current (I_{BIAS_N}) is increased, resulting in additional current being pulled in TIA circuit 200 at node N₂. In contrast, by turning OFF one or more switchable transistors (by pulling down the gate of the switchable transistors to ground) in the N-type bias current source 360, the total current (I_{BIAS_N}) is decreased, resulting in less current being pulled in TIA circuit 200 at node N₂.

Accordingly, the various switches allow individual switchable transistors to be enabled or disabled, creating a binary-weighted current adjustment capability. The total current (I_{BIAS_N}) can be discretely adjusted during calibration by controlling the switch settings through digital trim bits (e.g., TRIMₒ). This digital approach replaces the conventional analog method, where a continuous error signal from a feedback amplifier would adjust transistor gate voltages. During calibration, these switches are controlled based on comparing the internal common mode node (OUT_{CM_INT}) at the core amplifier section 204 and the reference common mode voltage (V_{CM}) to achieve the desired operating point.

The placement of the switches at the gate terminals of the transistors in Figure 3D, in contrast to the placement of the switches at the source terminals of the transistors in Figure 3B prevents a voltage drop on the switches due to high current. In addition, the arrangement shown in Figure 3D, similar to the arrangement shown in Figure 3C, improves current and device matching.

It should be appreciated that in some embodiments, switches may be placed at the gate terminals and the source terminals of the transistors (not shown) in a digitally trimmable N-type bias current source (i.e., a combination of the arrangement shown in Figures 3B and 3D). Further, the digitally trimmable N-type bias current source 360 may include additional components not shown. The number of transistors and switches of the digitally trimmable N-type bias current source 360 is non-limiting, and fewer or greater numbers are contemplated in embodiments. The switches in the bias current sources enable binary-weighted current adjustment, allowing the total current to be calibrated in discrete steps. This digital approach contrasts with conventional analog solutions that use continuous feedback signals. During the calibration process, the switches are controlled by comparing the internal common mode node (OUT_{CM_INT}) at the core amplifier section 204 and the reference common mode voltage (V_{CM}) to achieve the desired operating point.

In embodiments, the same digital trim bit (e.g., TRIMₒ, TRIM₁, etc.) but with reverse polarity can be used for the P-type bias current source 340 and the N-type bias current source 360, allowing for a single trim-bit change to modify both current sources with opposite impact (i.e., to increase P-side current and reduce N-side current simultaneously or vice-versa) simultaneously and extending the range for a single trim code.

In embodiments, the switches (SW_{P_o}, through SW_{P_M-1}, and SW_{N_o} through SW_{N_M-1}) are controllable by a controller (not shown) couplable to the switches. The controller sets the switches in the digitally trimmable P-type bias current sources 300 and 340 and the digitally trimmable N-type bias current sources 320 and 360 to equalize the internal common mode node (OUT_{CM_INT}) with the reference common mode voltage (V_{CM}).

The switches can be set to the OPEN state to reduce the current contribution, disconnecting their respective transistors from the current path. To increase the current contribution, switches can be set to the CLOSED state, enabling their respective transistors to contribute to the total current.

This digital control approach provides discrete current levels, unlike the conventional analog solution that offers continuous but potentially unstable adjustment. The discretization of current control eliminates the feedback loop instabilities while providing sufficient resolution to achieve the desired operating point. By replacing the problematic inner common mode feedback loop with the digital calibration mechanism, the design achieves stable operation without oscillation risks while maintaining the ultra-low noise performance required for high-performance radar receiver applications.

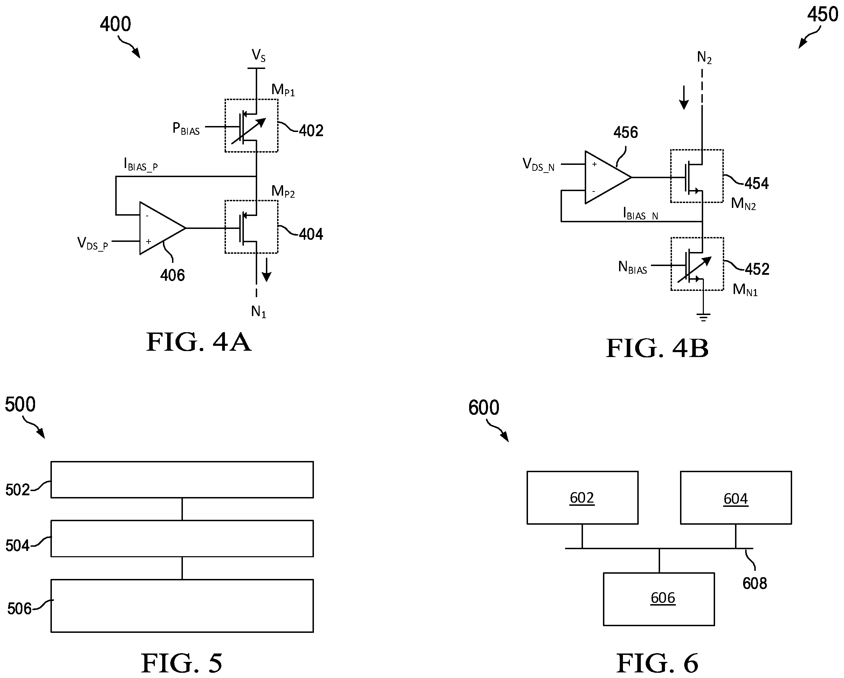

Figure 4A illustrates a schematic diagram of a digitally trimmable P-type bias current source 400, according to an embodiment of the disclosure. Similar to the digitally trimmable P-type bias current sources 300 and 340, the digitally trimmable P-type bias current source 206 in Figure 2A can be implemented as a gain boosted P-type bias current source 400 shown in Figure 4A.

The digitally trimmable P-type bias current source 400 includes a first P-channel transistor (M_{P1}) 402 and a second P-channel transistor (M_{P2}) 404 arranged in a cascode configuration. The first P-channel transistor (M_{P1}) 402 receives a P-type bias voltage (P_{BIAS}) at its gate terminal and is digitally controllable to increase/decrease current by applying a trim configuration. The source terminal of the first P-channel transistor (M_{P1}) 402 is coupled to the supply voltage (V_{S}). The source terminal of the second P-channel transistor (M_{P2}) 404 is coupled to the drain terminal of the first P-channel transistor (M_{P1}) 402. The drain terminal of the second P-channel transistor (M_{P2}) 404 is coupled to node N₁ of the TIA circuit 200. The inverting terminal of the operational amplifier 406 is coupled to the common node between the drain terminal of the first P-channel transistor (M_{P1}) 402 and the source terminal of the second P-channel transistor (M_{P2}) 404. The non-inverting terminal of the operational amplifier 406 is coupled to the reference bias (V_{DS_P}).

The operational amplifier 406 by feedback control ensures that the generated voltage bias signal (I_{BIAS_P}) is close to the reference bias (V_{DS_P}) and, thus, ensuring that the drain-source voltage of the first P-channel transistor (M_{P1}) 402 to be close to the reference bias (V_{DS_P}) across changes to process, voltage, and temperature. Based on this comparison, the operational amplifier 406 adjusts the gate voltage of the second P-channel transistor (M_{P2}) 404 to maintain the desired current level. Figure 4B illustrates a schematic diagram of a digitally trimmable N-type bias current source 450, according to another embodiment of the disclosure. Similar to the digitally trimmable N-type bias current sources 320 and 360, the digitally trimmable N-type bias current source 208 in Figure 2A, can be implemented as a gain boosted N-type bias current source 450 shown in Figure4B.

The digitally trimmable N-type bias current source 450 includes a first N-channel transistor (M_{N1}) 452 and a second N-channel transistor (M_{N2}) 454 arranged in a cascode configuration. The first N-channel transistor (M_{N1}) 452 receives an N-type bias voltage (N_{BIAS}) at its gate terminal and is digitally controllable to increase/decrease current by applying a trim configuration. The source terminal of the first N-channel transistor (M_{N1}) 452 is coupled to ground. The source terminal of the second N-channel transistor (M_{N2}) 454 is coupled to the drain terminal of the first N-channel transistor (M_{N1}) 452. The drain terminal of the second N-channel transistor (M_{N2}) 454 is coupled to node N₂ of the TIA circuit 200.

The inverting terminal of the operational amplifier 456 is coupled to the common node between the drain terminal of the first N-channel transistor (M_{N1}) 452 and the source terminal of the second N-channel transistor (M_{N2}) 454. The non-inverting terminal of the operational amplifier 406 is coupled to the reference bias (V_{DS_N}). The operational amplifier 456 by feedback control ensures that the generated voltage bias signal (I_{BIAS_N}) is close to the reference bias (V_{DS_N}) and, thus, ensuring that the drain-source voltage of the first N-channel transistor (M_{N1}) 452 to be close to the reference bias (V_{DS_N}) across changes to process, voltage, and temperature. Based on this comparison, the operational amplifier 456 adjusts the gate voltage of the second N-channel transistor (M_{N2}) 454 to maintain the desired current level. The digitally trimmable P-type bias current source 400 and digitally trimmable N-type bias current source 450 provide implementations for the bias current sources in the digitally stabilized transimpedance amplifier. These configurations offer several significant advantages over other implementations. First, the cascode arrangement and feedback control boost the output impedance, improving isolation and reducing loading effects. Second, the configurations exhibit lower Process, Voltage, and Temperature (PVT) drift due to the continuous feedback compensation provided by the operational amplifiers. Third, the configurations achieve higher Common Mode Rejection Ratio (CMRR) and Power Supply Rejection Ratio (PSRR), improving immunity to common mode disturbances and power supply variations.

These enhanced performance characteristics make the P-type bias current source 400 and N-type bias current source 450 particularly suitable for applications requiring exceptional stability and noise performance. These bias current sources along with the digital trimming help establish the proper operating point for the core amplifier section 204, ensuring that the internal common mode node (OUT_{CM_INT}) equals the reference common mode voltage (V_{CM}) for optimal performance. Choosing between the various implementations may depend on specific design requirements, including area constraints, power budget, and performance targets.

Figure 5 illustrates a flowchart of a calibration method 500 for calibrating a digitally stabilized transimpedance amplifier, according to an embodiment of the disclosure. Calibration method 500 provides a systematic approach to achieving proper biasing of the core amplifier section through digital calibration. In various embodiments, the method may include additional or fewer steps, or the steps may be performed differently than illustrated.

At step 502, the internal common mode node is measured. Referring to Figure 2A, this measurement can be measured at the core amplifier section 204. For instance, the measurement is performed using an analog-to-digital converter or comparator circuit that can capture the voltage level at this internal node and convert it to a digital representation for processing. For instance, step 502 comprises to measure OUT_{CM_INT}.

At step 504, the reference common mode voltage (V_{CM}) is measured. This reference voltage represents the target voltage level for proper biasing of the circuit and can be derived from a stable voltage reference. The measurement ensures that the current calibration process uses the actual reference voltage value rather than an assumed nominal value, accounting for any variations in the reference. For instance, step 504 comprises to measure V_{CM}.

At step 506, the bias current sources are set such that the measured internal common mode node (OUT_{CM_INT}) equals the measured reference common mode voltage (V_{CM}). The implementation of this step depends on the type of bias current sources used in the circuit. For instance, step 506 comprises to set digital current sources so that measure OUT_{CM_INT} equals V_{CM}.

For implementations using the digitally trimmable current sources shown in Figures 3A and 3B, this adjustment can be performed by, for example, setting digital trim bits that control the switches in the P-type bias current source 206 and the N-type bias current source 208. For instance, the trim bits are adjusted using a binary search algorithm or successive approximation approach. For example, if the internal common mode node (OUT_{CM_INT}) is lower than reference common mode voltage (V_{CM}), the P-type bias current source 206 may be increased (by closing more switches) or the N-type bias current source 208 may be decreased (by opening more switches). Conversely, if the internal common mode node (OUT_{CM_INT}) is higher than the reference common mode voltage (V_{CM}), the P-type bias current source 206 may be decreased or the N-type bias current source 208 may be increased.

In an embodiment, the P-type bias current source 206 is increased while the N-type bias current source 208 is simultaneously reduced. In another embodiment, the P-type bias current source 206 is decreased while the N-type bias current source 208 is simultaneously increased. In these embodiments, the simultaneous operation of the P-type bias current source 206 and the N-type bias current source 208 achieves the same objective with increased step size (i.e., doubled). Advantageously, this allows coverage of a larger range using the same number of digital trim codes.

For implementations using the variable transistor current sources shown in Figures 4A and 4B, the adjustment can involve setting the reference signals (i.e., V_{DS_P} and V_{DS_N}) as inputs to the operational amplifiers 406 and 456, respectively. These reference signals can be generated in a variety of ways. For example, the reference signals can be generated by pumping a proportional to absolute temperature (PTAT) current into a resistor ladder. As another example, the reference signals can be generated from a band-gap reference ladder. The operational amplifiers can automatically adjust the gate voltages of the second P-channel transistor (M_{P2}) 404 and the second N-channel transistor (M_{N2}) 454 to satisfy the desired current levels set from the digital controlled/ trimmed current sources the first P-channel transistor (M_{P1}) 402 and the first N-channel transistor (M_{N1}) 452.

The calibration method 500 can be performed as a foreground calibration during an initialization phase of the circuit operation, before normal signal processing begins. Once calibrated, the digital trim settings can be maintained during normal operation, eliminating the need for continuous feedback that could introduce instability. This approach combines the precision of feedback-based calibration without introducing complicated loops for stability, achieving optimal bias conditions without the risk of oscillation associated with conventional analog feedback loops.

Figure 6 illustrates a block diagram of a controller 600, according to an embodiment of the disclosure. The controller 600 can be coupled to the digitally stabilized TIA circuit 200 and the first-stage CMFB circuit 250 to implement the calibration method 500 described in Figure 5.

The controller 600 includes a processor 602, a memory 604, and an interface 606 interconnected via a communication bus 608. The processor 602 executes instructions stored in the memory 604 to perform the calibration operations, including measuring the internal common mode node (OUT_{CM_INT}), measuring the reference common mode voltage (V_{CM}), and setting the digital trim bits for the P-type bias current source 206 and N-type bias current source 208 to equalize these voltages.

The processor 602 may be implemented as various types of processing devices, including but not necessarily limited to a microprocessor, a digital signal processor (DSP), a microcontroller, a state machine, programmable logic, or any combination thereof. The processor 602 may operate at various clock speeds and power levels appropriate for the calibration requirements, and may include single or multiple processing cores depending on the complexity of the calibration algorithms and other processing needs.

The memory 604 may include transitory memory, non-transitory memory, or both. Transitory memory may include volatile memory such as static random-access memory (SRAM) or dynamic random-access memory (DRAM) for temporary storage of calibration data and intermediate results. For instance, non-transitory memory includes non-volatile memory such as flash memory, read-only memory (ROM), or electrically erasable programmable read-only memory (EEPROM) for storing calibration algorithms, trim bit settings, and other persistent data. In embodiments, the memory 604 stores instructions that, when executed by the processor 602, cause the processor 602 to perform the calibration method 500 described in Figure 5.

The interface 606 provides communication pathways between the controller 600 and the circuits being calibrated. For instance, it includes analog-to-digital converters (ADCs) for measuring the internal common mode node (OUT_{CM_INT}) and reference common mode voltage (V_{CM}).

For implementations using digitally trimmable current sources (Figures 3A-B), the interface 606 includes digital outputs for setting the trim bits. For instance, the interface 606 is designed to communicate with internal circuit nodes when the controller is integrated on the same die, or it includes additional buffering and level-shifting capabilities when interfacing with external components.

In an example, the controller 600 is implemented on the same integrated circuit die as the TIA circuit 200 and the first-stage CMFB circuit 250, enabling direct access to internal nodes for measurement and control. Alternatively, the controller 600 is implemented as an external component that interfaces with the integrated circuit through dedicated test pins or a standard communication protocol. In some embodiments, the controller 600 is a temporary external device used during manufacturing or initialization, with the calibration results stored in non-volatile memory for use during normal operation.

When executing calibration method 500, the controller 600 measures the internal common mode node (OUTV_{CM_INT}) through the interface 606 and the reference common mode voltage (V_{CM}). Based on comparing these values, the processor 602 executes algorithms to determine the optimal settings for the digitally trimmable current sources and applies these settings through the interface 606. For instance, the process is iterative, with multiple measurements and adjustments performed until the desired equality between the internal common mode node (OUT_{CM_INT}) and the reference common mode voltage (V_{CM}) is achieved within a specified tolerance.

For example, the controller 600 also implements additional features such as temperature compensation, periodic recalibration, or storage of multiple calibration settings for different operating conditions. These enhanced capabilities further improve the stability and performance of the digitally stabilized transimpedance amplifier across varying environmental conditions and over the device's lifetime.

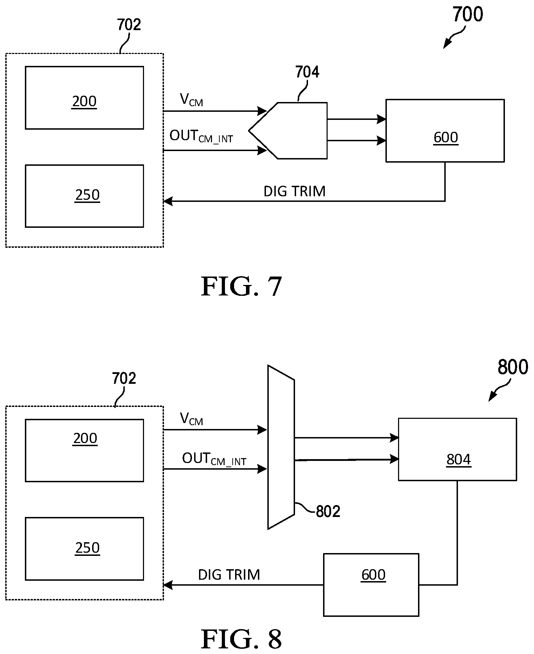

Figure 7 illustrates a digital trimming and calibration system 700, according to an embodiment of the disclosure. The calibration system 700 provides an example architecture for implementing the calibration method 500 described in Figure 5, showing the interconnections between the components involved in the calibration process.

The calibration system 700 includes a circuit 702 that includes the TIA circuit 200 and the first-stage CMFB circuit 250. The TIA circuit 200 corresponds to the digitally stabilized transimpedance amplifier shown in Figure 2A, while the first-stage CMFB circuit 250 corresponds to the common mode feedback circuit shown in Figure 2B.

A sense analog-to-digital converter (ADC) 704 receives the reference common mode voltage (V_{CM}) and the internal common mode node from the TIA circuit 200. The sense ADC 704 digitizes the analog voltage levels, enabling comparison between the measured values. The digitized values are provided to the controller 600, which corresponds to the controller described in Figure 6.

Based on the comparison between the reference common mode voltage (V_{CM}) and the internal common mode node (OUT_{CM_INT}), the controller 600 generates digital trim signals DIG TRIM that are fed back to the TIA circuit 200. The digital trim signals DIG TRIM control the bias current sources within the TIA circuit 200 to implement the calibration procedure.

The calibration procedure follows a systematic approach. First, the system measures the internal common mode node (OUT_{CM_INT}) and the reference common mode voltage (V_{CM}) through the sense ADC 704. Based on the comparison between these values, the controller 600 adjusts the bias currents according to specific rules: if the internal common mode node (OUT_{CM_INT}) is greater than the reference common mode voltage (V_{CM}), the controller increases the N-type bias current (I_{BIAS_N}), reduces the P-type bias current (I_{BIAS_P}), or both to have double impact by adjusting the appropriate binary trim bits. This adjustment lowers the internal common mode voltage toward the target reference value.

Conversely, if the internal common mode node (OUT_{CM_INT}) is less than the reference common mode voltage (V_{CM}), the controller increases the P-type bias current (I_{BIAS_P}), reduces the N-type bias current (I_{BIAS_N}), or both to have a double impact by adjusting the binary trim bits. This adjustment raises the internal common mode voltage toward the target reference value.

For instance, the controller 600 implements this adjustment process iteratively, making incremental changes to the trim bits and re-measuring the voltages until the internal common mode node (OUT_{CM_INT}) equals the reference common mode voltage (V_{CM}) within a specified tolerance. This iterative approach ensures precise calibration while avoiding overshoot or instability that could result from overly aggressive adjustments.

The digital trimming and calibration system 700 enables precise control of the TIA circuit's operating point without relying on continuous analog feedback loops that could introduce instability. By performing this calibration during an initialization phase and maintaining the trim settings during normal operation, the system achieves the benefits of feedback-based calibration with the simplicity of an open-loop system, addressing the limitations of conventional approaches.

In embodiments, circuit 702 represents a system on chip (SoC) that integrates the TIA circuit 200, the first-stage CMFB circuit 250, and potentially other components on a single semiconductor die. In some embodiments, the SoC 702 includes the controller 600, enabling an integrated circuit where calibration and temperature drift management functions are performed on-chip without requiring external components. In some embodiments, the controller 600 is implemented as a separate component that interfaces with the SoC 702, providing flexibility in system design and allowing the same controller to manage multiple SoCs in more complex systems. The specific integration approach may be selected based on die area constraints, power requirements, and system architecture considerations.

Figure 8 illustrates a test and calibration system 800, according to an embodiment of the disclosure. The calibration system 800 represents a manufacturing test configuration that enables calibration of the TIA circuit using external automated test equipment (ATE) 804.

Like Figure 7, the system includes a circuit 702 containing the TIA circuit 200 and the first-stage CMFB circuit 250. The reference common mode voltage (V_{CM}) and the internal common mode node (OUT_{CM_INT}) from circuit 702 are routed to a test multiplexer 802. The test multiplexer 802 allows these internal analog signals to be selectively brought to external pins for testing and calibration.

The calibration system 800 features automated test equipment (ATE) 804 coupled to the circuit 702 through input/output (I/O) pins. In embodiments, the ATE 804 is an off-chip test system used during semiconductor manufacturing to verify device functionality and perform calibration. The test multiplexer 802 can route the internal signals (V_{CM} and OUT_{CM__INT}) to the ATE 804, which can measure these voltages using its high-precision measurement capabilities.

The ATE 804 communicates with the controller 600 through interfaces, e.g., which include test protocols implemented via LabVIEW software or Serial Peripheral Interface (SPI) firmware. This communication channel allows the ATE 804 to instruct the controller 600 on adjustments to the digital trim settings based on the measured voltage values.

The operation of calibration system 800 is similar to calibration system 700, but leverages the precision and flexibility of external test equipment. The ATE 804 measures the reference common mode voltage (V_{CM}) and the internal common mode node (OUT_{CM_INT}) through the test multiplexer 802. Based on these measurements, the ATE 804 determines the appropriate adjustments and communicates them to the controller 600, which then sets the digital trim bits DIG TRIM to adjust the bias currents in the TIA circuit 200.

This test configuration can be advantageous during manufacturing, as it allows calibration using high-accuracy test equipment before the device is deployed in its final application. The calibration values determined during this process can be permanently stored in non-volatile memory within the controller 600, ensuring that the TIA circuit maintains optimal performance throughout its operational life. The calibration system 800 demonstrates the flexibility of the digital calibration approach, showing how it can be implemented through on-chip resources (as in Figure 7) and external test equipment during manufacturing. This dual approach ensures that the digitally stabilized transimpedance amplifier can achieve optimal performance regardless of process variations and other manufacturing factors.

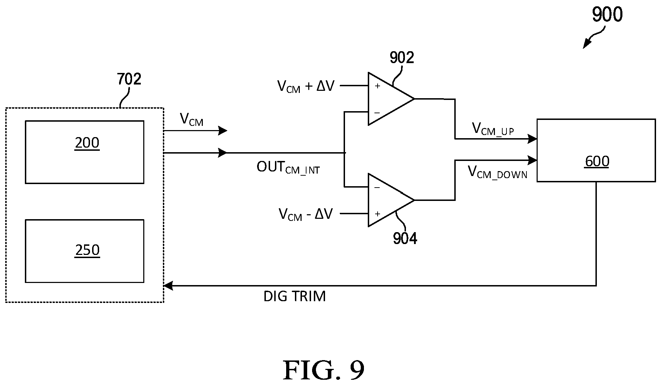

Figure 9 illustrates a temperature drift management and calibration system 900, according to an embodiment of the disclosure. The calibration system 900 extends the digital calibration approach to address temperature-induced drift in the internal common mode voltage, ensuring stable operation across varying thermal conditions.

Like previous figures, the system includes circuit 702, containing the TIA circuit 200 and the first-stage CMFB circuit 250. However, instead of analog-to-digital converters or test multiplexers, this system employs a first comparator 902 and a second comparator 904 that continuously monitor the relationship between the internal common mode node (OUT_{CM_INT}) and temperature-compensated reference thresholds (V_{CM} ± ΔV).

The first comparator 902 compares the internal common mode node (OUT_{CM_INT}) against an upper threshold (V_{CM} + ΔV), where ΔV represents a small voltage margin that establishes an upper bound for acceptable drift. The output of the first comparator 902 is a digital signal (V_{CM_UP}) that indicates whether the internal common mode node (OUT_{CM_INT}) has risen above the upper threshold.

The second comparator 904 compares the internal common mode node (OUT_{CM_INT}) against a lower threshold (V_{CM} - ΔV), establishing a lower bound for acceptable drift. The output of the second comparator 904 is a digital signal (V_{CM_DOWN}) that indicates whether the internal common mode node (OUT_{CM_INT}) has fallen below the lower threshold.

The comparator outputs are provided to the controller 600, which monitors their states to detect temperature-induced drift. After initial calibration, the system establishes a default state where the digital signal (V_{CM_UP}) is equal to '1' and the digital signal (V_{CM_DOWN}) equals 'o', indicating that the internal common mode node (OUT_{CM_INT}) is properly positioned between the two thresholds.

In embodiments, the temperature drift management operates as follows: if temperature changes cause the internal common mode node (OUT_{CM_INT}) to drift above the upper threshold (V_{CM} + ΔV), the digital signal (V_{CM_UP}) changes from '1' to '0'. Conversely, if the internal common mode node drifts below the lower threshold (V_{CM} - ΔV), the digital signal (V_{CM_DOWN}) changes from '0' to '1'. Either of these state changes indicates that the internal common mode voltage has drifted outside the acceptable window.

When such drift is detected, the controller 600 can trigger a recalibration process to adjust the digital trim bits DIG TRIM and restore the internal common mode node (OUT_{CM_INT}) to its proper value. This recalibration can be performed during idle periods of the radar system, such as between chirp sequences, to avoid disrupting normal operation.

The comparator-based approach provides a low-power, always-on monitoring solution that can quickly detect drift without requiring continuous measurement of the analog voltages. The width of the acceptable window, determined by ΔV, can be selected based on the system's sensitivity to common mode variations and the expected rate of temperature change.

Advantageously, the temperature drift management capability can enhance the robustness of the digitally stabilized transimpedance amplifier in real-world applications, where devices may experience substantial temperature variations during operation. The system can maintain optimal performance across its entire operating temperature range without requiring external intervention by automatically detecting and compensating for temperature-induced drift.

The embodiments of the disclosure provide advantages over conventional solutions for transimpedance amplifier design. In conventional approaches, dual common-mode feedback loops operate simultaneously, with an inner loop controlling internal bias points and an outer loop managing output common-mode voltage. These interacting loops create a complex dynamic system inherently prone to oscillations and instability, particularly across process, voltage, and temperature variations.

In contrast, the disclosed embodiments implement a different approach. During an initial calibration phase, digital trim bits DIG TRIM are set to specific values that equalize the internal common mode node with the reference common mode voltage (V_{CM}). Once the calibration is complete, these trim settings remain fixed during normal operation. This effectively means the inner common mode loop becomes inactive after calibration-it has fulfilled its purpose by establishing proper bias conditions and remains open during normal operation.

The result is a system that operates with a single active common-mode feedback loop (the outer loop) during normal operation, rather than dual interacting loops. The elimination of loop interaction removes the primary source of instability in conventional designs. With no interaction between inner and outer loops, there is no mechanism for oscillations to develop, significantly enhancing system stability across all operating conditions.

Further, the proposed embodiments maintain the ultra-low noise characteristics essential for high-performance radar applications. Removing the continuous analog feedback in the inner loop (present in the conventional solutions) eliminates the component size restrictions that conventional approaches impose to maintain stability. This allows optimal sizing of input transistors and bias currents to achieve the lowest possible noise figure without compromising stability.

The digital calibration approach provides superior immunity to process variations and aging effects. The ability to precisely set bias conditions through digital trimming, potentially with temperature drift compensation, ensures consistent performance across manufacturing variations and throughout the device lifetime. The combination of enhanced stability, ultra-low noise performance, and robustness to variations represents a significant advancement over conventional transimpedance amplifier designs for demanding radar applications.

A first aspect relates to a system, comprising a transimpedance amplifier (TIA) circuit including a core amplifier section having an internal common mode node, a first-stage common mode feedback circuit coupled to the core amplifier section, and a plurality of digitally trimmable bias current sources coupled to the core amplifier section; a sense analog-to-digital converter (ADC) coupled to the TIA circuit and configured to compare a first voltage measured at the internal common mode node with a second voltage measured at a reference common mode voltage; and a controller coupled to the sense ADC and the TIA circuit, the controller configured to: generate digital trim signals based on the comparison between the first voltage and the second voltage, and provide the digital trim signals to the digitally trimmable bias current sources to adjust a bias current such that the voltage at the internal common mode node equals the reference common mode voltage.

In a first implementation form of the system, according to the first aspect as such, the plurality of digitally trimmable bias current sources comprises a P-type bias current source including: a plurality of P-channel transistors arranged in parallel, each P-channel transistor sharing a common bias voltage at respective gate terminals; and a plurality of switches, each switch coupled to a respective one of the P-channel transistors and configured to selectively enable or disable the respective P-channel transistor based on the digital trim signals.

In a second implementation form of the system, according to the first aspect as such or any preceding implementation form of the first aspect, the plurality of digitally trimmable bias current sources comprises an N-type bias current source including: a plurality of N-channel transistors arranged in parallel, each N-channel transistor sharing a common bias voltage at respective gate terminals; and a plurality of switches, each switch coupled to a respective N-channel transistor and configured to selectively enable or disable the respective N-channel transistor based on the digital trim signals.

In a third implementation form of the system, according to the first aspect as such or any preceding implementation form of the first aspect, the plurality of digitally trimmable bias current sources comprises a P-type bias current source including: a first P-channel transistor having a gate terminal coupled to a P-type bias voltage; a second P-channel transistor coupled to the first P-channel transistor in a cascode configuration; and an operational amplifier having an output coupled to a gate terminal of the second P-channel transistor, a first input coupled to a bias reference signal, and a second input coupled to measure a drain-source voltage of the second P-channel transistor.

In a fourth implementation form of the system, according to the first aspect as such or any preceding implementation form of the first aspect, the plurality of digitally trimmable bias current sources comprises an N-type bias current source including: a first N-channel transistor having a gate terminal coupled to an N-type bias voltage; a second N-channel transistor coupled to the first N-channel transistor in a cascode configuration; and an operational amplifier having an output coupled to a gate terminal of the second N-channel transistor, a first input coupled to a bias reference signal, and a second input coupled to measure a drain-source voltage of the second N-channel transistor.

In a fifth implementation form of the system, according to the first aspect as such or any preceding implementation form of the first aspect, the controller is configured to: increase an N-type bias current, reduce a P-type bias current, or both in response to the first voltage being greater than the second voltage; and increase the P-type bias current, reduce the N-type bias current, or both in response the first voltage being less than the second voltage.

In a sixth implementation form of the system, according to the first aspect as such or any preceding implementation form of the first aspect, the controller and the TIA circuit are integrated on a single semiconductor die.

A second aspect relates to a system, comprising a circuit including: a transimpedance amplifier (TIA) having an internal common mode node, a first-stage common mode feedback circuit coupled to the TIA, and a plurality of digitally trimmable bias current sources coupled to the TIA; a test multiplexer coupled to the circuit and configured to selectively route the internal common mode node and a reference common mode voltage to external pins; automated test equipment (ATE) couplable to the external pins and configured to compare a first voltage measured at the internal common mode node with a second voltage measured at the reference common mode voltage; and a controller couplable to the ATE and the circuit, the controller configured to: receive comparison results from the ATE, generate digital trim signals based on the comparison results, and provide the digital trim signals to the digitally trimmable bias current sources to adjust bias currents such that the first voltage equals the second voltage.

In a first implementation form of the system, according to the second aspect as such, the plurality of digitally trimmable bias current sources comprises a P-type bias current source including: a plurality of P-channel transistors arranged in parallel, each P-channel transistor sharing a common bias voltage at respective gate terminals; and a plurality of switches, wherein one or more switches are coupled to a respective P-channel transistor and configured to selectively enable or disable the respective P-channel transistor based on the digital trim signals.

In a second implementation form of the system, according to the second aspect as such or any preceding implementation form of the second aspect, the plurality of digitally trimmable bias current sources comprises an N-type bias current source including: a plurality of N-channel transistors arranged in parallel, each N-channel transistor sharing a common bias voltage at respective gate terminals; and a plurality of switches, wherein one or more switches are coupled to a respective N-channel transistor and configured to selectively enable or disable the respective N-channel transistor based on the digital trim signals.

In a third implementation form of the system, according to the second aspect as such or any preceding implementation form of the second aspect, the plurality of digitally trimmable bias current sources comprises a P-type bias current source including: a first P-channel transistor having a gate terminal coupled to a P-type bias voltage; a second P-channel transistor coupled to the first P-channel transistor in a cascode configuration; and an operational amplifier having an output coupled to a gate terminal of the second P-channel transistor, a first input coupled to a bias reference signal, and a second input coupled to measure a drain-source voltage of the second P-channel transistor.

In a fourth implementation form of the system, according to the second aspect as such or any preceding implementation form of the second aspect, the plurality of digitally trimmable bias current sources comprises an N-type bias current source including: a first N-channel transistor having a gate terminal coupled to an N-type bias voltage; a second N-channel transistor coupled to the first N-channel transistor in a cascode configuration; and an operational amplifier having an output coupled to a gate terminal of the second N-channel transistor, a first input coupled to a bias reference signal, and a second input coupled to measure a drain-source voltage of the second N-channel transistor.

In a fifth implementation form of the system, according to the second aspect as such or any preceding implementation form of the second aspect, the ATE communicates with the controller through a standardized interface using test protocols implemented via software or firmware.

In a sixth implementation form of the system, according to the second aspect as such or any preceding implementation form of the second aspect, the controller is configured to store calibration values determined during testing in non-volatile memory for use during normal operation of the TIA.

A third aspect relates to a system, comprising a circuit including: a transimpedance amplifier (TIA) having an internal common mode node, a first-stage common mode feedback circuit coupled to the TIA, and a plurality of digitally trimmable bias current sources coupled to the TIA; a first comparator having a first input coupled to the internal common mode node, a second input coupled to a first threshold voltage equal to a reference common mode voltage plus a voltage margin, and an output providing a first comparator signal; a second comparator having a first input coupled to the internal common mode node, a second input coupled to a second threshold voltage equal to the reference common mode voltage minus the voltage margin, and an output providing a second comparator signal; and a controller coupled to the first and second comparators and the circuit, the controller configured to: monitor the first comparator signal and the second comparator signal, detect temperature-induced drift when either of the first comparator and the second comparator signals changes state, and adjust the digitally trimmable bias current sources to restore a voltage at the internal common mode node to a value between the first and second threshold voltages.

In a first implementation form of the system, according to the third aspect as such, the plurality of digitally trimmable bias current sources comprises a P-type bias current source including: a plurality of P-channel transistors arranged in parallel, each P-channel transistor sharing a common bias voltage at respective gate terminals; and a plurality of switches, each switch coupled to a respective one of the P-channel transistors and configured to selectively enable or disable the respective P-channel transistor based on digital trim signals from the controller.

In a second implementation form of the system, according to the third aspect as such or any preceding implementation form of the third aspect, the plurality of digitally trimmable bias current sources comprises an N-type bias current source including: a plurality of N-channel transistors arranged in parallel, each N-channel transistor sharing a common bias voltage at respective gate terminals; and a plurality of switches, each switch coupled to a respective one of the N-channel transistors and configured to selectively enable or disable the respective N-channel transistor based on digital trim signals from the controller.

In a third implementation form of the system, according to the third aspect as such or any preceding implementation form of the third aspect, the plurality of digitally trimmable bias current sources comprises a P-type bias current source including: a first P-channel transistor having a gate terminal coupled to a P-type bias voltage; a second P-channel transistor coupled to the first P-channel transistor in a cascode configuration; and an operational amplifier having an output coupled to a gate terminal of the second P-channel transistor, a first input coupled to a bias reference signal, and a second input coupled to measure a drain-source voltage of the second P-channel transistor.

In a fourth implementation form of the system, according to the third aspect as such or any preceding implementation form of the third aspect, the controller is configured to trigger a recalibration process during idle periods of operation to adjust the digitally trimmable bias current sources in response to the temperature-induced drift being detected.

In a fifth implementation form of the system, according to the third aspect as such or any preceding implementation form of the third aspect, after an initial calibration, a default state is established where the first comparator signal is at a first logic level and the second comparator signal is at a second logic level, and wherein the controller detects temperature-induced drift in response to either the first comparator signal changing from the first logic level or the second comparator signal changing from the second logic level.

Although the description has been described in detail, it should be understood that various changes, substitutions, and alterations may be made without departing from the spirit and scope of this disclosure as defined by the appended claims. The same elements are designated with the same reference numbers in the various figures. Moreover, the scope of the disclosure is not intended to be limited to the particular embodiments described herein, as one of ordinary skill in the art will readily appreciate from this disclosure that processes, machines, manufacture, compositions of matter, means, methods, or steps, presently existing or later to be developed, may perform substantially the same function or achieve substantially the same result as the corresponding embodiments described herein. Accordingly, the appended claims are intended to include within their scope such processes, machines, manufacture, compositions of matter, means, methods, or steps.

The specification and drawings are, accordingly, to be regarded simply as an illustration of the disclosure as defined by the appended claims, and are contemplated to cover any and all modifications, variations, combinations, or equivalents that fall within the scope of the present disclosure.

## Claims

1. A system (700), comprising:
a transimpedance amplifier, TIA circuit (200) including:
a core amplifier section (204) having an internal common mode node and a plurality of digitally trimmable bias current sources (206, 208, 300, 320, 340, 360, 400, 450; 702) coupled to the core amplifier section (204), and
a first-stage common mode feedback circuit (250) coupled to the core amplifier section (204);
a sense analog-to-digital converter, ADC (704) coupled to the TIA circuit (200) and configured to compare a first voltage measured at the internal common mode node (OUT_{CM_INT}) with a second voltage measured at a reference common mode voltage (V_{CM}); and
a controller (600) coupled to the sense ADC (704) and the TIA circuit (200), the controller (600) configured to:
generate digital trim signals (DIG TRIM) based on the comparison between the first voltage (OUT_{CM_INT}) and the second voltage (V_{CM}), and
provide the digital trim signals (DIG TRIM) to the digitally trimmable bias current sources (206, 208, 300, 320, 340, 360, 400, 450; 702) to adjust a bias current (I_{P_BIAS}, I_{N_BIAS}) such that the voltage at the internal common mode node (OUT_{CM_INT}) equals the reference common mode voltage(V_{CM}),
preferably wherein the controller (600) and the TIA circuit (200) are integrated on a single semiconductor die.

2. The system (700) of claim 1, wherein the plurality of digitally trimmable bias current sources (206, 208, 300, 340, 702) comprises a P-type bias current source (340; I_{BIAS_P}) including:
a plurality of P-channel transistors (M_{P1}, M_{P_SW_M}) arranged in parallel, each P-channel transistor in the plurality of P-channel transistors (M_{P1}, M_{P_SW_M}) sharing a common bias voltage at respective gate terminals (P_{BIAS}); and
a plurality of switches (SW_{P_o},..., SW_{P_M-1}), each switch in the plurality of switches (SW_{P_o},..., SW_{P_M-1}) being coupled to a respective one of the P-channel transistors in the plurality of P-channel transistors (M_{P1}, M_{P_SW_M}) and being configured to selectively enable or disable the respective P-channel transistor based on the digital trim signals (DIG TRIM), and/or, wherein the plurality of digitally trimmable bias current sources (206, 208, 320, 360) comprises an N-type bias current source (360; I_{BIAS_N}) including:
a plurality of N-channel transistors (M_{N1}, M_{N_SW_M}) arranged in parallel, each N-channel transistor in the plurality of N-channel transistors (M_{N1}, M_{N_SW_M}) sharing a common bias voltage at respective gate terminals (N_{BIAS}); and
a plurality of switches (SW_{N_o},..., SW_{N_M-1}), each switch in the plurality of switches (SW_{N_o},..., SW_{N_M-1}) being coupled to a respective N-channel transistor in the plurality of N-channel transistors (M_{N1}, M_{N2}) and being configured to selectively enable or disable the respective N-channel transistor based on the digital trim signals (DIG TRIM).

3. The system (700) of claim 1, wherein the plurality of digitally trimmable bias current sources (206, 208, 400) comprises a P-type bias current source (400) including:
a first P-channel transistor (402) having a gate terminal (P_{BIAS}) coupled to a P-type bias voltage;
a second P-channel transistor (404) coupled to the first P-channel transistor (402) in a cascode configuration; and
an operational amplifier (406) having an output coupled to a gate terminal of the second P-channel transistor (404), a first input coupled to a bias reference signal (I_{BIAS_P}), and a second input coupled to measure a drain-source voltage (V_{DS_P}) of the second P-channel transistor (404), and/or, wherein the plurality of digitally trimmable bias current sources (206, 208, 450) comprises an N-type bias current source (450) including:
a first N-channel transistor (452) having a gate terminal (N_{BIAS}) coupled to an N-type bias voltage;
a second N-channel transistor (454) coupled to the first N-channel transistor (452) in a cascode configuration; and
an operational amplifier (456) having an output coupled to a gate terminal of the second N-channel transistor (454), a first input coupled to a bias reference signal (I_{BIAS_N}), and a second input coupled to measure a drain-source voltage (V_{DS_N}) of the second N-channel transistor (454).

4. The system (700) of claim 1, wherein the controller (600) is configured to:
increase an N-type bias current (I_{N_BIAS}), reduce a P-type bias current (I_{P_BIAS}), or both (I_{N_BIAS}, I_{P_BIAS}) in response to the first voltage (OUT_{CM_INT}) being greater than the second voltage (V_{CM}); and
increase the P-type bias current (I_{P_BIAS}),, reduce the N-type bias current (I_{N_BIAS}), or both (I_{N_BIAS}, I_{P_BIAS}) in response the first voltage (OUT_{CM_INT}) being less than the second voltage (V_{CM}).

5. A system (800), comprising:
a circuit (702) including:
a transimpedance amplifier (TIA) circuit (200) having an internal common mode node (OUT_{CM_INT}) and a plurality of digitally trimmable bias current sources (206, 208, 300, 320, 340, 360, 400, 450), and
a first-stage common mode feedback circuit (250) coupled to the TIA circuit (200);
a test multiplexer (802) coupled to the circuit (702) and configured to selectively route the internal common mode node and a reference common mode voltage (V_{CM}) to external pins;
automated test equipment, ATE (804) couplable to the external pins and configured to compare a first voltage measured at the internal common mode node (OUT_{CM_INT}) with a second voltage measured at the reference common mode voltage (V_{CM}); and
a controller (600) couplable to the ATE (804) and the circuit (702), the controller (600) configured to:
receive comparison results from the ATE (804),
generate digital trim signals (DIG TRIM) based on the comparison results, and
provide the digital trim signals (DIG TRIM) to the digitally trimmable bias current sources (206, 208, 300, 320, 340, 360, 400, 450) to adjust bias currents such that the first voltage (OUT_{CM_INT}) equals the second voltage(V_{CM}).

6. The system (800) of claim 5, wherein the plurality of digitally trimmable bias current sources (206, 208, 300, 340) comprises a P-type bias current source (I_{BIAS_P}) including:
a plurality of P-channel transistors (M_{P1},..., M_{P_M-1}) arranged in parallel, each P-channel transistor in the plurality of P-channel transistors (M_{P1},..., M_{P_M-1}) sharing a common bias voltage at respective gate terminals (P_{BIAS}); and
a plurality of switches (SW_{P_o},..., SW_{P_M-1}), wherein one or more switches in the plurality of switches (SW_{P_o},..., SW_{P_M-1}) are coupled to a respective P-channel transistor in the plurality of P-channel transistors (M_{P1},..., M_{P_M-1}) and configured to selectively enable or disable the respective P-channel transistor based on the digital trim signals (DIG TRIM), and/or, wherein the plurality of digitally trimmable bias current sources (206, 208, 320, 360) comprises an N-type bias current source (I_{BIAS_N}) including:
a plurality of N-channel transistors (M_{N1},..., M_{N_M-1}) arranged in parallel, each N-channel transistor in the plurality of N-channel transistors (M_{N1},..., M_{N_M-1}) sharing a common bias voltage at respective gate terminals (N_{BIAS}); and
a plurality of switches (SW_{N_o},..., SW_{N_M-1}), wherein one or more switches in the plurality of switches (SW_{N_o},..., SW_{N_M-1}) are coupled to a respective N-channel transistor in the plurality of N-channel transistors (M_{N1},..., M_{N_M-1}) and configured to selectively enable or disable the respective N-channel transistor based on the digital trim signals (DIG TRIM).

7. The system (800) of claim 5, wherein the plurality of digitally trimmable bias current sources (206, 208, 400) comprises a P-type bias current source (I_{BIAS_P}) including:
a first P-channel transistor (402) having a gate terminal (P_{BIAS}) coupled to a P-type bias voltage;
a second P-channel transistor (452) coupled to the first P-channel transistor (402) in a cascode configuration; and
an operational amplifier (406) having an output coupled to a gate terminal of the second P-channel transistor (404), a first input coupled to a bias reference signal (I_{BIAS_P}), and a second input coupled to measure a drain-source voltage (V_{DS_P}) of the second P-channel transistor (404) and/or, wherein the plurality of digitally trimmable bias current sources (206, 208, 450) comprises an N-type bias current source (I_{BIAS_N}) including:
a first N-channel transistor (452) having a gate terminal (N_{BIAS}) coupled to an N-type bias voltage;
a second N-channel transistor (454) coupled to the first N-channel transistor (402) in a cascode configuration; and
an operational amplifier (456) having an output coupled to a gate terminal of the second N-channel transistor (404), a first input coupled to a bias reference signal (I_{BIAS_N}), and a second input coupled to measure a drain-source voltage (V_{DS_N}) of the second N-channel transistor (404).

8. The system (800) of claim 6, wherein the ATE (804) communicates with the controller (600) through a standardized interface using test protocols implemented via software or firmware.

9. The system (800) of claim 5, wherein the controller (600) is configured to store calibration values determined during testing in non-volatile memory (604) for use during normal operation of the TIA circuit.

10. A system (900), comprising:
a circuit (702) including:
a transimpedance amplifier, TIA circuit (200) having an internal common mode node (OUT_{CM_INT}) and a plurality of digitally trimmable bias current sources (206, 208, 300, 320, 340, 360, 400, 450), and
a first-stage common mode feedback circuit (250) coupled to the TIA circuit (200);
a first comparator (902) having a first input coupled to the internal common mode node (OUT_{CM_INT}), a second input coupled to a first threshold voltage equal to a reference common mode voltage plus a voltage margin, and an output providing a first comparator signal;
a second comparator (904) having a first input coupled to the internal common mode node (OUT_{CM_INT}), a second input coupled to a second threshold voltage equal to the reference common mode voltage minus the voltage margin, and an output providing a second comparator signal; and
a controller (600) coupled to the first comparator (902), the second comparator (904), and the circuit (200), the controller (600) configured to:
monitor the first comparator signal and the second comparator signal,
detect temperature-induced drift in response to the first comparator or the second comparator signals changing state, and
adjust the digitally trimmable bias current sources (206, 208, 300, 320, 340, 360, 400, 450) to restore a voltage at the internal common mode node (OUT_{CM_INT}) to a value between the first and second threshold voltages.

11. The system (900) of claim 10, wherein the plurality of digitally trimmable bias current sources (206, 208, 300, 340) comprises a P-type bias current source including:
a plurality of P-channel transistors arranged in parallel, each P-channel transistor sharing a common bias voltage at respective gate terminals; and
a plurality of switches, each switch coupled to a respective one of the P-channel transistors and configured to selectively enable or disable the respective P-channel transistor based on digital trim signals from the controller (600), and/or, wherein the plurality of digitally trimmable bias current sources (206, 208, 320, 360) comprises an N-type bias current source including:
a plurality of N-channel transistors arranged in parallel, each N-channel transistor sharing a common bias voltage at respective gate terminals; and
a plurality of switches, each switch coupled to a respective one of the N-channel transistors and configured to selectively enable or disable the respective N-channel transistor based on digital trim signals from the controller (600).

12. The system (900) of claim 10, wherein the plurality of digitally trimmable bias current sources (206, 208, 300, 320, 340, 360, 400, 450) comprises a P-type bias current source including:
a first P-channel transistor having a gate terminal coupled to a P-type bias voltage;
a second P-channel transistor coupled to the first P-channel transistor in a cascode configuration; and
an operational amplifier (406) having an output coupled to a gate terminal of the second P-channel transistor, a first input coupled to a bias reference signal, and a second input coupled to measure a drain-source voltage of the second P-channel transistor.

13. The system (900) of claim 10, wherein the controller (600) is configured to trigger a recalibration process during idle periods of operation to adjust the digitally trimmable bias current sources (206, 208, 300, 320, 340, 360, 400, 450) in response to the temperature-induced drift being detected.

14. The system (900) of claim 10, wherein after an initial calibration, a default state is established where the first comparator signal is at a first logic level and the second comparator signal is at a second logic level, and wherein the controller (600) detects temperature-induced drift in response to the first comparator signal changing from the first logic level or the second comparator signal changing from the second logic level.
